# EUROPEAN PATENT SPECIFICATION

(11) **EP 2 661 560 B1**
(45) Date of publication and mention of the grant of the patent: **05.02.2020**
(21) Application number: 11802228.4
(22) Date of filing: 06.12.2011
(51) Int. Cl.: H01L 23/473, F04B 43/00, F04B 43/04, F04B 45/047

(54) **SYNTHETIC JET PACKAGING**
VERKAPSELUNG VON SYNTHETISCHEN STRAHLDÜSEN
ACTIONNEUR À JET SYNTHÉTIQUE

(30) Priority: 04.01.2011 US 984488
(43) Date of publication of application: 13.11.2013
(73) Proprietor: General Electric Company, Schenectady, NY 12345 (US)
(72) Inventor: ARIK, Mehmet, Niskayuna, NY 12309 (US); GURSOY, Mustafa, 06520 Cankaya, Ankara (TR); PETROSKI, James, Parma OH 44134 (US)
(74) Representative: Dennemeyer & Associates S.A.
(86) International application number: PCT/US2011/063362
(87) International publication number: WO 2012/094085

(56) References cited:
- EP-A1- 1 515 043
- EP-A1- 1 762 725
- EP-A2- 1 715 519
- US-A1- 2005 219 288
- US-A1- 2006 056 999
- US-A1- 2007 139 938
- US-A1- 2008 156 462
- US-A1- 2009 167 109

## Description

### BACKGROUND OF THE INVENTION

The subject matter disclosed herein relates to synthetic jets and more particularly to synthetic jet packaging.

Microchips, LEDs, radio frequency components, memory chips, and other electronic devices may generate a significant amount of heat during use. These electronic devices should dissipate this energy in order to prevent damage and to extend their useful life. At times, the environment surrounding the electronic devices may be unable to provide the necessary cooling. In situations were the environment is unable to effectively cool, a cooling device may be included. The cooling device may therefore provide the necessary cooling in combination with the environment to extend the life and protect the electronic device. When including a cooling device to assist in heat removal, the cooling device itself may introduce a number of additional design challenges.
EP 1 715 519 A2 describes a jet generating device and electronic apparatus. US 2007/139938 A1 describes an LED light with active cooling. US 2009/167109 A1 describes a piezoelectric pump cooling device, and electronic apparatus. US 2008/0156462, considered as the closest prior art, describes a synthetic-jet-based system for cooling an electronics package, employing multiple membranes. Each of EP 1 762 725, EP 1 515 043 and US 2006/0056999 describes a synthetic-jet based gas ejector.

### BRIEF DESCRIPTION OF THE INVENTION

Aspects of the invention are defined in the appended claims. In one embodiment, a cooling system includes a housing, a connector within the housing capable of communicating with an exterior power source, driver electronics within the housing, and a first membrane within the housing and a second membrane within the housing, wherein the first and second membranes are connected to the driver electronics. The housing includes a top section and a bottom section. A first synthetic jet is formed between the first membrane and the top section of the housing, a second synthetic jet is formed between the first and second membranes and a third synthetic jet is formed between the second membrane and the bottom section of the housing.

### BRIEF DESCRIPTION OF THE DRAWINGS

These and other features, aspects, and advantages of the present invention will become better understood when the following detailed description is read with reference to the accompanying drawings in which like characters represent like parts throughout the drawings, wherein:
FIG. 1 is a block diagram of a synthetic jet device, in accordance with an embodiment of the invention;
FIG. 2 is an exemplary synthetic jet compressing/expelling air;
FIG. 3 is an exemplary synthetic jet expanding/ingesting air;
FIG. 4 is a perspective view of a synthetic jet device, in accordance with an embodiment of the invention;
FIG. 5 is a top view of the synthetic jet device in FIG. 4, in accordance with an embodiment of the invention;
FIG. 6 is a perspective view of a synthetic jet device, in accordance with an embodiment of the invention; and
FIG. 7 is a top view of the synthetic jet device in FIG. 6, in accordance with an embodiment of the invention.

### DETAILED DESCRIPTION OF THE INVENTION

Embodiments of the invention generally relate to a synthetic jet device for cooling electronic devices. For example, the device may provide convective cooling for microchips, LEDs, heatsinks, radio components, memory chips, etc. As discussed in detail below, the synthetic jet device advantageously combines all components into a single device. Specifically, the synthetic jet device includes a housing with a connector, power electronics, an actuator, and one or more membranes all within the housing. Furthermore, the device advantageously forms multiple synthetic jets by using the surfaces of the housing in combination with the membranes. Thus, the device creates additional synthetic jets without increasing the number of membranes.

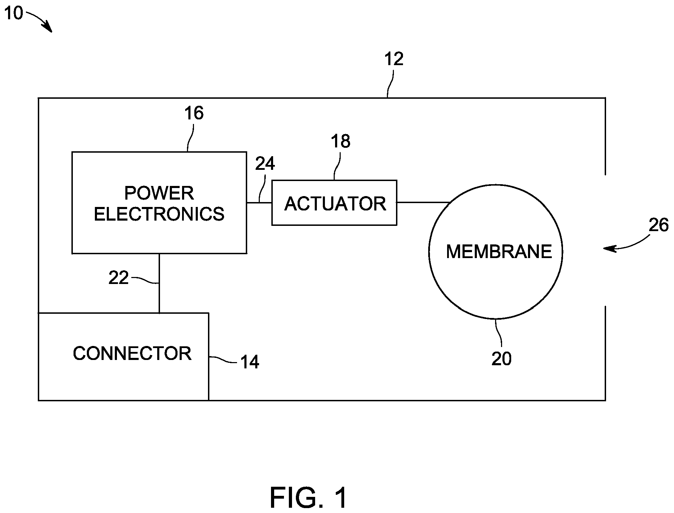

Turning to the figures, FIG. 1 is a block diagram of a synthetic jet device 10, in accordance with an embodiment of the invention. The synthetic jet device 10 includes a housing 12, connector 14, power electronics 16, actuator 18, and membrane 20. As seen in FIG. 1 the synthetic jet device advantageously includes the connector 14, power electronics 16, actuator 18, and membrane 20 within housing 12, thus, creating a self-contained unit. By including, all of these components in a single package the synthetic jet device 10 may advantageously be inserted into an existing system or may be simply removed and replaced when damaged. For example, a system in need of additional cooling may not need a special design to incorporate these components, but instead may provide the necessary power to operate the synthetic jet device 10.

During operation, the synthetic jet device 10 receives power from an external source through the connector 14. The external power supply may provide power in the form of alternating current (A/C) or direct current (D/C). The connector 14 passes this power on to power electronics 16 through an electrical connection 22. In addition to its function as an electrical connector, the connector 14 may also function as a physical connector. For example, the connector 14 may physically connect and orient the synthetic jet device 10 in a system. Thus, the connector 14 may properly position the synthetic jet device 10 to cool necessary components or locations in a system. Further, the connector 14 may facilitate electrical communication between the power electronics 16 and the system to which it attaches. Alternatively, the synthetic jet device 10 may be powered by a battery (not shown) in place of the connector 14, such that the power electronics 16 are powered by the battery, rather than an external source.

The power electronics 16 may be a general purpose integrated circuit or an application specific integrated circuit (ASIC). For example, the power electronics may include an ASIC designed specifically for the operation of the synthetic jet device 10. During operation, the power electronics 16 control the timing and release of power to an actuator(s) 18 through an electrical connection 24. For example, during operation, the power electronics 16 may receive signals through the connector 14 indicating that the system, electrical component, etc., needs more or less cooling. Specifically, the power electronics 16 may receive a signal indicating the need for increased cooling. The power electronics 16 may then increase power and/or timing to the actuator 18 for movement of the membrane 20. Likewise, if less cooling is required the power electronics 16 may slow the timing and/or decrease power to the actuator(s) 18.

The actuator 18 may control movement of the membrane 20 in a variety of ways. For example, the actuator 18 may drive the membrane with an electromagnetic actuator, a piezoelectric actuator, a mechanical actuator (i.e., piston), etc. As the actuator 18 drives the membrane 20, the membrane 20 moves air out of the housing 12 through an aperture 26. As the air passes out of the housing 12 it creates a cooling convective airflow over a specific location or component in a system. This convective airflow may assist in preventing premature wear, damage, etc. by supporting heat removal.

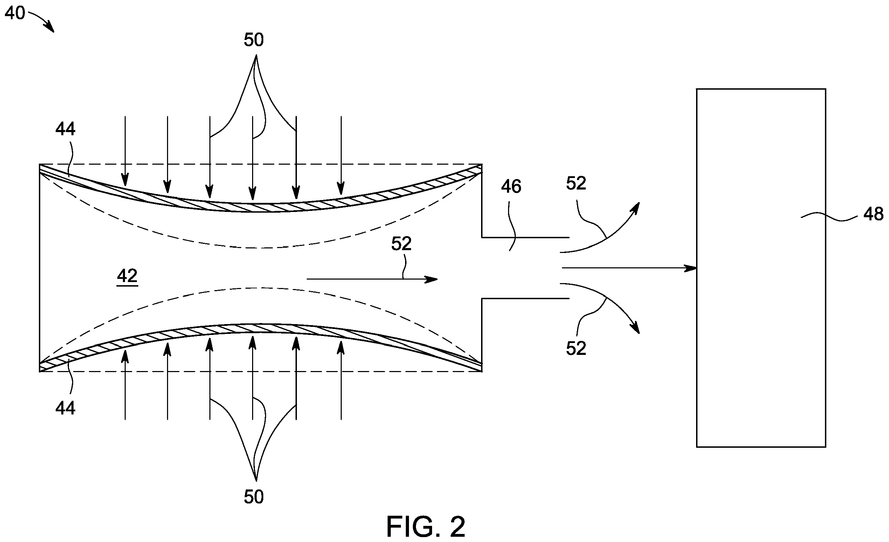

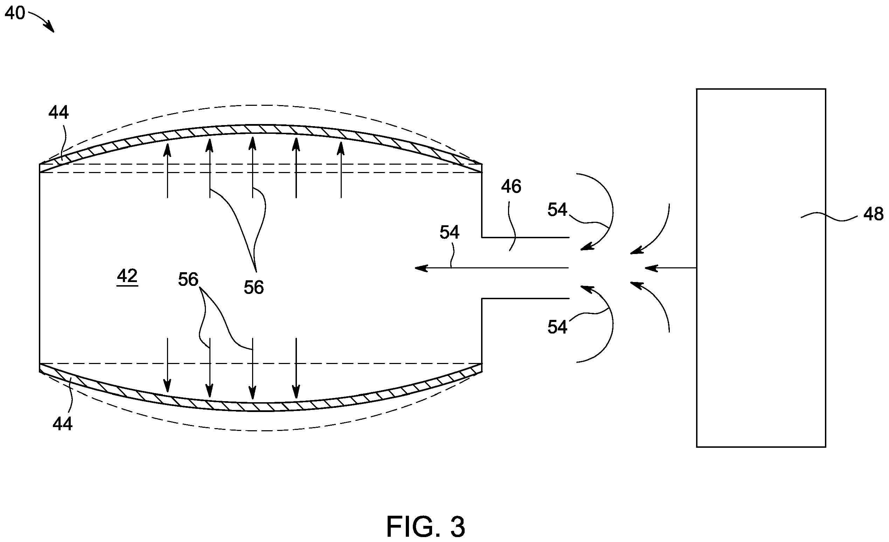

FIGS. 2 and 3 illustrate an exemplary synthetic jet 40 compressing/expelling and expanding/ingesting air. As will be appreciated, synthetic jets, such as the synthetic jet 40, are zero-net-mass flow devices that include a cavity or volume of air 42 enclosed by at least one flexible membrane, and typically at least two flexible membranes 44, and a small aperture 46 through which air can pass. The membranes 44 deform in a periodic manner causing a corresponding suction and expulsion of air through the aperture 46. As air flows out of the synthetic jet 40 it impinges on surface 48 were it convectively cools the surface.

As illustrated in FIG. 2 the synthetic jet 40 is undergoing a compressing/expelling step. Specifically, the membranes 44 are moving in the direction of arrows 50. As the membranes 44 move in the direction of the arrows 50 they reduce the volume 42 and create pressure. The increase in pressure creates a pressure differential between air inside the volume 42 and air outside of the aperture 46. The difference in pressure causes the air 52 to flow out of the volume 42 and into the relatively low-pressure location outside the aperture 46, until the pressure equalizes.

In FIG. 3, the synthetic jet 40 is undergoing an expanding/ingesting air step. As illustrated, the membranes 44 are moving in the direction of arrows 56, which increases the volume 42. The expansion of volume 42 reduces the air pressure in volume 42, creating an air pressure differential. The difference in pressure between the volume 42 and the air outside of the aperture 46 attracts the relatively high-pressure air 54 to enter the volume 42, until the pressure equalizes. Once the volume 42 fills with air, the membranes 44 repeat the compressing/expelling step illustrated in FIG. 2.

Accordingly, the synthetic jet 40 imparts a net positive momentum to its external fluid, here ambient air. During each cycle, this momentum manifests as a self-convecting vortex dipole that emanates away from the aperture 46. The vortex dipole then impinges on the surface 48 to be cooled, i.e., microchips, LEDs, memory chips, etc., disturbing the boundary layer and convecting the heat away from its source. Over steady state conditions, this impingement mechanism develops circulation patterns near the heated component and facilitates mixing between the hot air and ambient fluid.

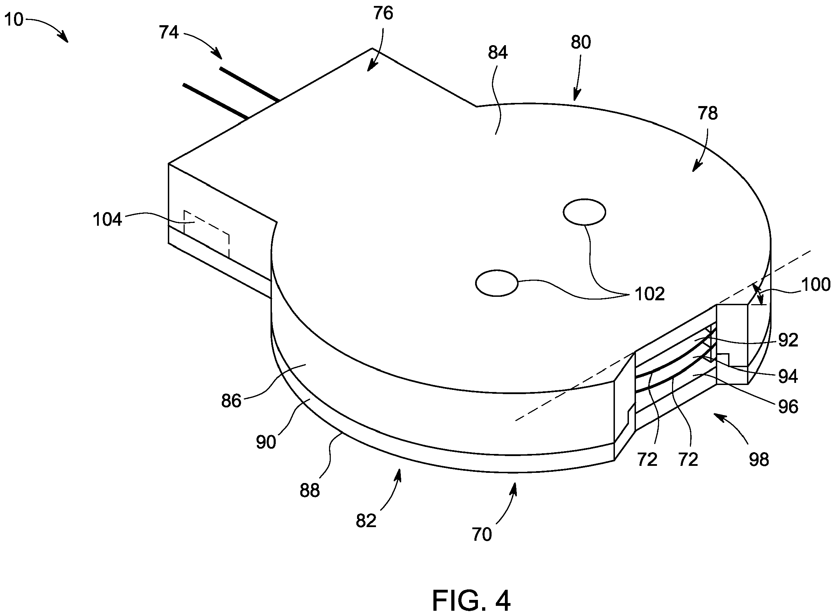

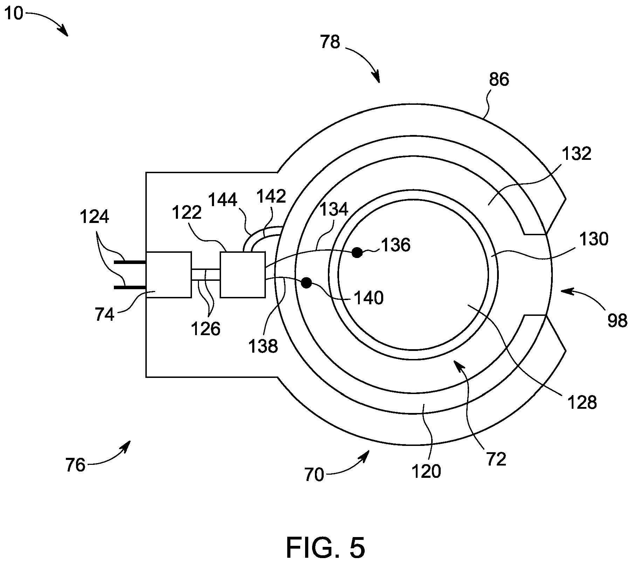

FIG. 4 is a perspective view of a synthetic jet device 10, in accordance with an embodiment of the invention. The synthetic jet device 10 includes a housing 70, membranes 72, and connector 74. As illustrated the housing 70 forms an irregular shape with a generally rectangular portion 76 connected to a generally circular portion 78. The rectangular portion 76 may advantageously provide sufficient room to include the connector 74 and power electronics (seen in FIG. 5) within the same housing 70 as the membranes 72. In addition, the housing 70 includes a top section 80 and a bottom section 82. As illustrated, the top section 80 defines a top surface 84 and a sidewall 86. The bottom section 82 may likewise define a bottom surface 88 and a sidewall 90.

It is the membranes 72 that create the cooling airflow. In the present embodiment, the two membranes 72 advantageously create three synthetic jets 92, 94, and 96. The first synthetic jet 92 is formed between a membrane 72 and the top section 80 of the housing 70. The second synthetic jet 94 is formed between the two membranes 72. The third synthetic jet 96 is formed between a membrane 72 and the bottom section 82 of the housing 70. Thus, by using the top and bottom sections 80, 82 the device 10 creates two additional synthetic jets without additional membranes 72. In other embodiments, there may be any number of membranes 72, e.g., 1, 2, 3, 4, 5, 6, 7, etc. In still other embodiments, there may be a stiff disk in-between each of the membranes 72. For example, a stiff disk may be positioned between membranes 72 in FIG. 4. The stiff disk in between membranes 72 may advantageously increase the synthetic jet count from three to four without adding an additional membrane 72.

In order to ingest and expel air with membranes 72 the housing 70 defines an aperture 98. In the present embodiment the aperture 98 is formed in the housing opposite the connector 74, but in other embodiments may be formed anywhere on the housing 70. Furthermore, to improve airflow in and out of the housing 70 the sidewalls 86 and 90 may form an angle 100 with the aperture 98. For example, the sides walls 86 and 90 may form an angle 100 of 0-90 degrees, 15-75 degrees, or 30-60 degrees with respect to the aperture 98. Accordingly, optimization of the airflow including direction, speed, and volume may occur by changing the angle 100 and the size of aperture 98.

Furthermore, the top and bottom surfaces 84 and 88 may include apertures 102 to assist in ingesting and expelling air. The apertures 102 prevent excessive pressure buildup within the housing 70 that may damage the membranes 72 and hinder smooth fluid flow or reduce the performance of the synthetic jet. As illustrated, in FIG. 4 there are two apertures 102 on the top surface 84. While not shown in FIG. 4, there are similarly two apertures on the bottom surface 88. In other embodiments, there may be any number of apertures 102. For example, there may be 0, 1, 2, 3, 4, 5, 10, 15, 20, etc., apertures on the top or bottom surfaces 84 and 88. Furthermore, and depending on the embodiment, these apertures 102 may form different shapes and occupy different positions on the top and bottom surfaces 84, 88.

In the present embodiment, the connector 74 is positioned opposite the aperture 98. In other embodiments the connector may be positioned at different locations on the rectangular portion 76. For example, the connector may be position at position 104. The ability to move the connector 74 to different positions facilitates proper orientation of the device 10. With proper orientation the device 10 may maximize cooling effectiveness.

FIG. 5 is a top view of the synthetic jet device 10 in FIG. 4 with the top surface 84 removed, in accordance with an embodiment of the invention. As illustrated, within the housing 70 is the connector 74, membrane 72, frame 120, and power electronics 122. The connector 74 includes two prongs 124 that conduct power to the power electronics 122 through electrical lines 126. While in the present embodiment two prongs 124 are shown, other embodiments may include a connector 74 with apertures that receive prongs from the power source. Further, other types of connectors 74 may also be used.

After passing through the connector 74 the power enters the power electronics 122. As mentioned above, rectangular portion 76 may advantageously provide space to contain the power electronics 122 and connector 74. Furthermore, the power electronics 122 may be an ASIC designed specifically for driving the synthetic jet device 10. For example, the ASIC may time when the membranes 72 flex and how much they flex by controlling the amount and timing of power to the membranes 72. Thus, the membranes 72 may bend in sync, out of sync, or one membrane may bend more than another membrane 72, etc.

As mentioned above, an electromagnetic actuator, a piezoelectric actuator, a mechanical actuator (i.e., piston), etc., may drive the membranes 72. In the present embodiment, a piezoelectric actuator drives the membrane 72. For example, the piezoelectric components may be similar to piezoelectric buzzer elements. In particular, the membrane includes a piezoelectric disk 128 connected with glue 130 to a shim (i.e., disk) 132. Indeed, the glue 130 attaches and holds the piezoelectric disk 128 in position on the shim 132. Furthermore, the shim 132 is held in place with the elastomeric frame 120. Thus, the frame 120 permits oscillation of the membrane(s) 72 by suspending the piezoelectric disk 128 and shim 132 within the housing 70.

During operation, power exits the power electronics 122 through electrical line 134 and connects to the piezoelectric disk 128 at connection point 136. In order for current to flow, a ground wire 138 connects to the shim 132 at connection point 140. As the electricity enters the piezoelectric element 128 it causes the piezoelectric element 128 to expand. The expansion of the piezoelectric element 128 causes the membrane 72 to bend. For example, the piezoelectric element 128 may receive sinusoidal power causing the membrane 72 to bend sinusoidally up and down. This kind of movement causes the membrane(s) 72 to ingest and then expel air out of the housing 70, thus, providing a cooling airflow. In addition to wires 134 and 138, the device 10 includes wires 142 and 144. While not shown, the wires 142 and 144 connect to the other membrane 72 providing power to the other piezoelectric disk. As explained above, in other embodiments there may be more than two membranes 72. Each of these membranes requires power and as a result there may be an additional two wires exiting the power electronics 122 for each additional membrane 72.

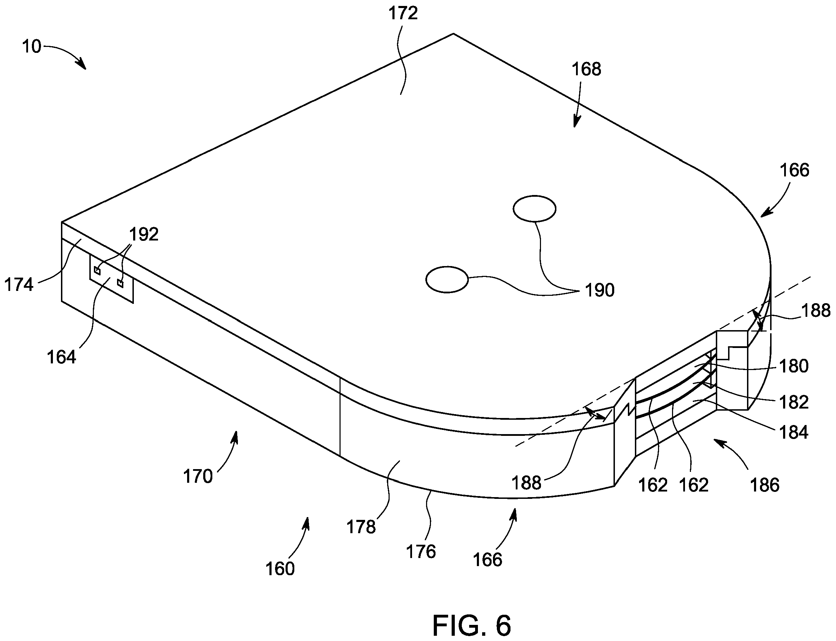

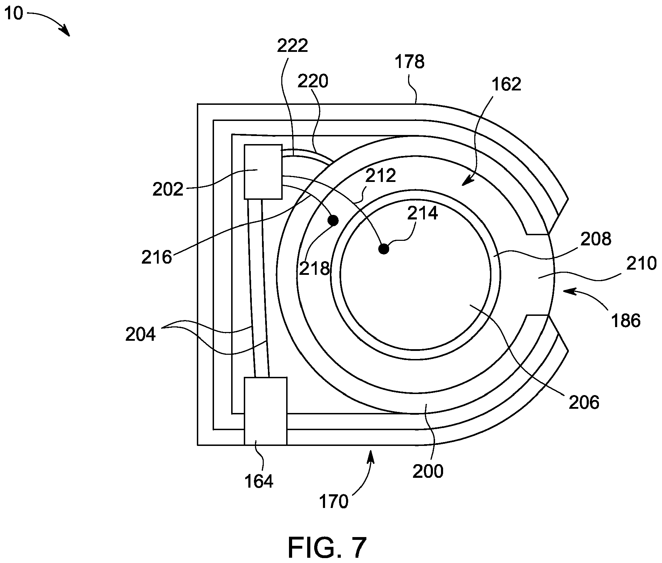

FIG. 6 is a perspective view of a synthetic jet device 10, in accordance with an embodiment of the invention. The synthetic jet device 10 includes a housing 160, membranes 162, and connector 164. As illustrated, the housing 160 forms an irregular shape with a generally rectangular shape with rounded corners 166. The housing 160 may advantageously provide sufficient room to include the connector 164 and power electronics (seen in FIG. 7) within the same housing 160 as the membranes 162. In addition, the housing 160 includes a top section 168 and a bottom section 170. As illustrated, the top section 168 defines a top surface 172 and a sidewall 174. The bottom section 170 may likewise define a bottom surface 176 and a sidewall 178.

Similar to the device described in FIG. 4, the device 10 of FIG. 6 creates a cooling airflow with membranes 162. Specifically, the two membranes 162 advantageously create three synthetic jets 180, 182, and 184. As explained above, by using the top and bottom sections 168, 170, the device 10 creates two additional synthetic jets without additional membranes 162. In other embodiments, there may be any number of membranes 162, e.g., 1, 2, 3, 4, 5, 6, 7, etc. In still other embodiments, there may be a stiff disk in-between each of the membranes 162. For example, a stiff disk may be positioned between membranes 162. The stiff disk positioned between membranes 162 may advantageously increase the number of synthetic jets from three to four.

In order to ingest and expel air with membranes 162 the housing 160 defines an aperture 186. In the present embodiment the aperture 186 is formed in-between the rounded corners 166, but in other embodiments may be formed anywhere on the housing 160. Furthermore, to direct or improve airflow in and out of the housing 160 the sidewalls 174 and 178 may form an angle 188 with the aperture 186. For example, the sides walls 174 and 178 may form an angle of 0-90 degrees, 15-75 degrees, or 30-60 degrees with respect to the aperture 186. Accordingly, optimization of the airflow direction, speed, and volume may occur by changing the angle 188 and the size of aperture 186.

The housing 160 may also include apertures 190 on the top and bottom surfaces 172 and 176. The apertures 190 may prevent excessive pressure buildup within the housing 160 that may cause damage to the membranes 162 and hinder smooth fluid flow. As illustrated, in FIG. 6 there are two apertures 190 on the top surface. While not shown in FIG. 6 there are similarly two apertures 190 on the bottom surface 176. Moreover, while FIG. 6 only illustrates two apertures 190, other embodiments may include any number of apertures 190. For example, there may be 0, 1, 2, 3, 4, 5, 10, 15, 20, etc., apertures on the top or bottom surfaces 172 and 176. Depending on the embodiment, these apertures 190 may form different shapes and occupy different positions on the top and bottom surfaces 172, 176. For example, the apertures 190 may be square-like, rectangular, oval-like, etc.

In the present embodiment, the connector 164 includes two ports 192 instead of two prongs. Similar to the discussion above, and depending on the embodiment, the connector 164 may include ports, prongs, a ribbon connector, etc. Furthermore, the connector 164 may be positioned at different locations on the rectangular portion 160. The ability to move the connector 164 to different positions facilitates placement and orientation of the device 10. By properly orienting the device 10, cooling effectiveness may improve.

FIG. 7 is a top view of the synthetic jet device 10 in FIG. 6 without the top section 168, wherein the in accordance with an embodiment of the invention. As illustrated, the device 10 advantageously includes the connector 164, membrane 162, frame 200, and power electronics 202 all within the housing 160.

The device 10 receives power through the connector 164. The power may be supplied by an A/C or D/C source. The power travels along lines 204 to the power electronics 202. As mentioned above, housing 160 may advantageously provide space to contain the power electronics 202 and connector 164. Like the power electronics 122 of FIG. 5, the power electronics 202 may be an ASIC designed specifically for driving the synthetic jet device 10. For example, the ASIC may time when the membranes 162 flex and how much they flex by controlling the amount and timing of power to the membranes 162. Thus, the power electronics 202 may optimize the cooling flow while simultaneously saving power.

As discussed above, an electromagnetic actuator, a piezoelectric actuator, a mechanical actuator (i.e., piston), etc., may drive the membranes 162. In the present embodiment, a piezoelectric actuator drives the membrane 162. As illustrated, the membrane 162 includes a piezoelectric disk 206 that connects with glue 208 to a shim (i.e., disk) 210. More specifically, the glue 208 attaches and holds the piezoelectric disk 206 in place on the shim 210. Furthermore, the shim 210 is held in place with the elastomeric frame 200. Thus, the frame 200 suspends the piezoelectric disk 206 and shim 210 within the housing 160. Accordingly, because of the suspension, the piezoelectric disk 206 is able to oscillate within the housing 160.

During operation, power travels through the power electronics 202 and power line 212 and into the piezoelectric disk 206 at connection point 214. In order for current to flow, a ground wire 216 connects to the shim 210 at connection point 218. As the electricity enters the piezoelectric element 206 it causes the piezoelectric element 206 to expand, and when the power stops it contracts. Thus, by expanding and contracting the piezoelectric element 206 the overall membrane 162 bends. For example, the piezoelectric element 206 may receive sinusoidal power causing the membrane 162 to bend sinusoidally up and down. This kind of movement causes the membrane(s) 162 to ingest and then expel air out of the housing 160. In addition to wires 212 and 216, the device 10 includes wires 220 and 222. While not shown, the wires 220 and 222 connect to the other membrane 162 providing power to another piezoelectric disk (seen in FIG. 6). In embodiments that include more than two membranes 162 there may be additional wires that connect the membranes 162 to the power electronics 202.

Technical effects of the invention include combining a connector, membranes, and power electronics, within a single housing. Accordingly, the device may cool an existing system, preventing the redesign of the system to include synthetic jets. Furthermore, because the device includes all the components within a single housing, it may be easily replaced when broken or used. Finally, the device advantageously uses the housing surfaces in combination with the membranes to form additional synthetic jets.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims.

## Claims

1. A cooling system (10), comprising:
a housing (70; 160), including a top section (80; 168) and a bottom section (82; 170);
a connector (74; 164) within the housing (70; 160) capable of communicating with an exterior power source;
a first membrane (72; 162) within the housing (70, 160), wherein the first membrane (72; 162) is connected to driver electronics; and
a second membrane (72; 162) connected to the driver electronics;
wherein a first synthetic jet (92) is formed between the first membrane (72;162) and the top section (80; 168) of the housing (70, 160), a second synthetic jet (94) is formed between the first and second membranes (72; 162) and a third synthetic jet 96) is formed between the second membrane (72; 162) and the bottom section (82;
170) of the housing (70, 160);
**characterized in that** the driver electronics are located within the housing (70, 160).

2. The cooling system (10), as set forth in claim 1, wherein the housing (70; 160) defines a wall and an aperture (102; 190) through the wall.

3. The cooling system (10), as set forth in claim 2, wherein the wall forms an angle of between 0-90 degrees with respect to the aperture (102; 190).

4. The cooling system (10), as set forth in claim 2, wherein the wall forms an angle between 0-30 degrees with respect to the aperture (102; 190).

5. The cooling system (10), as set forth in claim 1, wherein the membranes (72; 162) include a piezoelectric actuator.

6. The cooling system (10), as set forth in claim 5, wherein the piezoelectric actuator is a piezoelectric disk.

7. The cooling system (10), as set forth in claim 1, wherein the housing (70; 160) defines a top surface and a bottom surface with at least one respective aperture (102; 190) through each of the top and bottom surfaces and wherein the apertures are configured to reduce pressure in the housing (70; 160).

8. The cooling system (10), as set forth in claim 1, wherein the housing (70; 160) includes a rectangular portion connected to a circular portion.

9. The cooling system (10), as set forth in claim 8, wherein the rectangular portion contains the connector (74; 164) and the driver electronics while the circular portion contains the first and second membranes (72; 162).

10. The cooling system (10), as set forth in claim 1, wherein the housing (70; 160) defines a rectangular shape with rounded corners on one side.

11. The cooling system (10), as set forth in claim 1, wherein the driver electronics comprise an application specific integrated chip.

## Patentansprüche

1. Kühlsystem (10), umfassend:
ein Gehäuse (70; 160), das einen oberen Abschnitt (80; 168) und einen unteren Abschnitt (82; 170) einschließt;
ein Verbindungsstück (74; 164) innerhalb des Gehäuses (70; 160), das in der Lage ist, mit einer äußeren Energiequelle zu kommunizieren;
eine erste Membran (72; 162) innerhalb des Gehäuses (70, 160), wobei die erste Membran (72; 162) mit der Treiberelektronik verbunden ist; und
eine zweite Membran (72; 162), die mit der Treiberelektronik verbunden ist;
wobei ein erster synthetischer Strahl (92) zwischen der ersten Membran (72; 162) und dem oberen Abschnitt (80; 168) des Gehäuses (70, 160) gebildet ist, ein zweiter synthetischer Strahl (94) zwischen der ersten und der zweiten Membran (72; 162) gebildet ist und ein dritter synthetischer Strahl (96) zwischen der zweiten Membran (72; 162) und dem unteren Abschnitt (82; 170) des Gehäuses (70, 160) gebildet ist;
**dadurch gekennzeichnet, dass** sich die Treiberelektronik innerhalb des Gehäuses (70, 160) befindet.

2. Kühlsystem (10) nach Anspruch 1, wobei das Gehäuse (70; 160) eine Wand und eine Öffnung (102; 190) durch die Wand definiert.

3. Kühlsystem (10) nach Anspruch 2, wobei die Wand einen Winkel von zwischen 0 und 90 Grad in Bezug auf die Öffnung (102; 190) bildet.

4. Kühlsystem (10) nach Anspruch 2, wobei die Wand einen Winkel von zwischen 0 und 30 Grad in Bezug auf die Öffnung (102; 190) bildet.

5. Kühlsystem (10) nach Anspruch 1, wobei die Membranen (72; 162) einen piezoelektrischen Aktuator einschließen.

6. Kühlsystem (10) nach Anspruch 5, wobei der piezoelektrische Aktuator eine piezoelektrische Platte ist.

7. Kühlsystem (10) nach Anspruch 1, wobei das Gehäuse (70; 160) eine obere Fläche und eine untere Fläche mit mindestens einer Öffnung (102; 190) durch jede der oberen und unteren Flächen definiert und wobei die Öffnungen konfiguriert sind, um den Druck in dem Gehäuse (70; 160) zu reduzieren.

8. Kühlsystem (10) nach Anspruch 1, wobei das Gehäuse (70; 160) einen rechteckigen Abschnitt einschließt, der mit einem kreisförmigen Abschnitt verbunden ist.

9. Kühlsystem (10) nach Anspruch 8, wobei der rechteckige Abschnitt das Verbindungsstück (74; 164) und die Treiberelektronik enthält, während der kreisförmige Abschnitt die erste und die zweite Membran (72; 162) enthält.

10. Kühlsystem (10) nach Anspruch 1, wobei das Gehäuse (70; 160) eine rechteckige Form mit abgerundeten Ecken auf einer Seite definiert.

11. Kühlsystem (10) nach Anspruch 1, wobei die Treiberelektronik einen anwendungsspezifischen integrierten Chip umfasst.

## Revendications

1. Système de refroidissement (10) comprenant :
un boîtier (70, 160), comprenant une section supérieure (80, 168) et une section inférieure (82, 170) ;
un connecteur (74, 164) à l'intérieur du boîtier (70, 160) capable de communiquer avec une source d'alimentation extérieure ;
une première membrane (72, 162) à l'intérieur du boîtier (70, 160), la première membrane (72, 162) étant connectée à un circuit électronique de commande ; et
une seconde membrane (72, 162) connectée au circuit électronique de commande ;
dans lequel un premier jet synthétique (92) est formé entre la première membrane (72, 162) et la section supérieure (80 ; 168) du boîtier (70, 160), un deuxième jet synthétique (94) est formé entre les première et la seconde membranes (72, 162) et un troisième jet synthétique (96) est formé entre la seconde membrane (72, 162) et la section inférieure (82, 170) du boîtier (70, 160) ;
**caractérisé en ce que** le circuit électronique de commande est situé dans le boîtier (70, 160).

2. Système de refroidissement (10) selon la revendication 1, dans lequel le boîtier (70, 160) définit une paroi et une ouverture (102, 190) à travers la paroi.

3. Système de refroidissement (10) selon la revendication 2, dans lequel la paroi forme un angle compris entre 0 et 90 degrés par rapport à l'ouverture (102, 190).

4. Système de refroidissement (10) selon la revendication 2, dans lequel la paroi forme un angle compris entre 0 et 30 degrés par rapport à l'ouverture (102, 190).

5. Système de refroidissement (10) selon la revendication 1, dans lequel les membranes (72 ; 162) comprennent un actionneur piézoélectrique.

6. Système de refroidissement (10) selon la revendication 5, dans lequel l'actionneur piézoélectrique est un disque piézoélectrique.

7. Système de refroidissement (10) selon la revendication 1, dans lequel le boîtier (70, 160) définit une surface supérieure et une surface inférieure, dotées d'au moins une ouverture respective (102 ; 190) à travers chacune des surfaces supérieure et inférieure, et dans lequel les ouvertures sont conçues pour réduire la pression dans le boîtier (70 ; 160).

8. Système de refroidissement (10) selon la revendication 1, dans lequel le boîtier (70, 160) comprend une partie rectangulaire reliée à une partie circulaire.

9. Système de refroidissement (10) selon la revendication 8, dans lequel la partie rectangulaire contient le connecteur (74, 164) et le circuit électronique de commande, tandis que la partie circulaire contient les première et seconde membranes (72, 162).

10. Système de refroidissement (10) selon la revendication 1, dans lequel le boîtier (70 ; 160) définit une forme rectangulaire présentant des coins arrondis sur un côté.

11. Système de refroidissement (10) selon la revendication 1, dans lequel le circuit électronique de commande comprend une puce intégrée propre à l'application.
